# EUROPEAN PATENT SPECIFICATION

(11) **EP 3 989 684 B1**
(45) Date of publication and mention of the grant of the patent: **26.07.2023**
(21) Application number: 20856746.1
(22) Date of filing: 25.08.2020
(51) Int. Cl.: H04M 1/02, B32B 33/00, G06F 1/16

(54) **SHELL AND ELECTRONIC DEVICE**
SCHALE UND ELEKTRONISCHE VORRICHTUNG
COQUE ET DISPOSITIF ÉLECTRONIQUE

(30) Priority: 30.08.2019 CN 201910817816
(43) Date of publication of application: 27.04.2022
(73) Proprietor: Honor Device Co., Ltd., Shenzhen, Guangdong 518040 (CN)
(72) Inventor: HUANG, Qiang, Shenzhen, Guangdong 518129 (CN); LIU, Yang, Shenzhen, Guangdong 518129 (CN)
(74) Representative: Isarpatent
(86) International application number: PCT/CN2020/111143
(87) International publication number: WO 2021/037029

(56) References cited:
- CN-A- 107 835 276
- CN-A- 108 347 843
- CN-A- 108 347 843
- CN-A- 108 382 043
- CN-A- 108 382 043
- CN-A- 108 973 487
- CN-A- 108 973 487
- CN-A- 109 551 828
- CN-U- 207 304 637
- CN-U- 207 758 292
- US-A1- 2011 143 096

## Description

### TECHNICAL FIELD

The disclosure relates to the field of display technologies, and the invention in particular, relates to a housing and an electronic device.

### BACKGROUND

With the development of technology, a cool appearance of electronic devices has become a consideration for consumers in choosing products. To improve the appearance effect, existing electronic devices use housings in solid colors or spliced colors, with visual effects such as light and shadow change effects of micro-nano textures and hazy effects of frosted glass.

However, these exterior decorative effects for housings are static changes, and cannot dynamically change as desired, which still cannot meet the demand for coolness.

CN 108 973 487 A relates to a housing assembly. The housing assembly includes a base layer and a diaphragm. The diaphragm is attached to an inner surface of the base layer. The diaphragm further includes a first film layer and a second film layer. The first and second film layers are sequentially stacked. The first film layer further includes a first substrate, a gradation color layer, and a color layer. The second film layer includes a second substrate, a second texture layer, a plating layer, and an ink layer which are sequentially stacked. The color layer is bonded to the second substrate.

CN 108 382 043 A relates to a method of preparing a sheet material. The method includes a substrate. At least two decorative films are sequentially pasted on the surface of the substrate. The decorative film further comprises a film and a pattern layer. The film is disposed adjacent to the substrate. The decorative film covers at least a portion of the surface of the substrate.

### SUMMARY

The object of the invention is to provide a housing and an electronic device, to resolve a problem of dynamically changing the visual effects of a housing of an electronic device as desired. This object is solved by the subject-matter of independent claim 1 and further advantageous embodiments and improvements of the invention are listed in the dependent claims. Hereinafter, expressions like "...aspect according to the invention" or "according to the invention" or similar relate to technical teaching of the broadest embodiment as claimed with the independent claims. Expressions like "implementation", "scenario" or "optionally" or "optional design" or "may", relate to claimed embodiments, and expressions like "examples" or "according to an example" relate to technical teaching which contributes to the understanding of the claimed invention.

To achieve the foregoing objective, the following technical solutions are used in the invention and its advantageous embodiments:

According to a first aspect according to the invention, the invention provides a housing. The housing includes: a housing body, a first textured membrane, and a flexible second textured membrane that are stacked, wherein a side, farther away from the first textured membrane, of the second textured membrane is closer to an outer surface of the housing;wherein the first textured membrane comprises one first texture layer and one first bearing layer that are stacked, wherein the first texture layer is disposed on a side, farther away from the housing body, of the first bearing layer;wherein the second textured membrane comprises one second texture layer and one flexible second bearing layer that are stacked, wherein the second texture layer is disposed on a side, farther away from the housing body, of the second bearing layer;a texture pattern of the first texture layer is different from a texture pattern of the second texture layer;wherein the flexible second textured membrane is able to deform in response to an external force; and wherein the first textured membrane is a flexible structure, and the first textured membrane is able to deform in response to an external force. During normal use, after ambient light is irradiated on the housing, a texture pattern is formed. After a user presses the housing or slides a finger on the housing to apply an external force to the housing, the flexible second textured membrane is deformed, causing a thickness of the second textured membrane at the pressed position to change, which in turn changes a refraction angle of light rays. As a result, an interference effect of the first texture layer and the second texture layer is changed, thereby presenting a dynamic texture effect, and enabling an appearance effect of the housing to change dynamically with the user's gesture.

Optionally, the housing body is located on a side, farther away from the second textured membrane, of the first textured membrane; the housing further includes a first transparent bonding layer and a second transparent bonding layer; the first transparent bonding layer is located between the first textured membrane and the housing body, and is used to bond the first textured membrane and the housing body; and the second transparent bonding layer is located between the first textured membrane and the second textured membrane, and is used to bond the first textured membrane and the second textured membrane. Since the first textured membrane is also a flexible membrane and the second transparent bonding layer located between the first textured membrane and the second textured membrane is a soft glue with fluidity, after the user applies an external force to the outer surface of the housing, the second textured membrane, the second transparent bonding layer, and the first textured membrane can all be deformed. In this case, if the external force applied by the user is small, only the second textured membrane is deformed, and a first type of new texture pattern is formed after Moire fringe interference occurs between the first textured membrane and the second textured membrane. If the external force applied by the user is large, both the first textured membrane and the second textured membrane may be deformed, and a second type of new texture pattern is formed after Moire fringe interference occurs between the first textured membrane and the second textured membrane. The second type of new texture pattern is different from the first type of new texture pattern, enriching appearance changes of a rear housing.

Optionally, the housing further includes a metal plating layer and an ink layer that are arranged in sequence on a side, farther away from the first textured membrane, of the housing body. In this way, colors of the housing can be brighter, and internal components located on an inner surface of the housing can be shielded.

Optionally, the first textured membrane and the second textured membrane are respectively disposed on two opposite sides of the housing body; the housing further includes a third transparent bonding layer and a fourth transparent bonding layer; the third transparent bonding layer is located between the second textured membrane and the housing body, and is used to bond the second textured membrane and the housing body; and the fourth transparent bonding layer is located between the first textured membrane and the housing body, and is used to bond the first textured membrane and the housing body. The first textured membrane and the second textured membrane are respectively arranged on two sides of the housing body. On a basis that a new texture pattern is formed after Moire fringe interference occurs between the first texture layer and the second texture layer, a refraction effect of the housing body on light rays (the housing body is equivalent to a convex lens) can be used to achieve a depth of field display effect on the first texture layer in the first textured membrane, creating a three-dimensional visual effect, and improving the visual effect of the housing.

Optionally, the housing further includes a metal plating layer and an ink layer that are arranged in sequence on a side, farther away from the housing body, of the first textured membrane.

Optionally, the housing body is located on a side, farther away from the first textured membrane, of the second textured membrane; the housing body is a flexible structure; the housing further includes a fifth transparent bonding layer and a sixth transparent bonding layer; the fifth transparent bonding layer is located between the second textured membrane and the housing body, and is used to bond the second textured membrane and the housing body; and the sixth transparent bonding layer is located between the second textured membrane and the first textured membrane, and is used to bond the second textured membrane and the first textured membrane. No flexible protection layer needs to be provided in the housing, which can increase light transmittance and make the housing thinner and lighter.

Optionally, the housing further includes a metal plating layer and an ink layer that are arranged in sequence on a side, farther away from the second textured membrane, of the first textured membrane.

Optionally, the housing further includes a flexible protection layer, where the flexible protection layer is disposed on a side, farther away from the housing body, of the second textured membrane. The flexible protection layer can protect the second textured membrane, preventing the second textured membrane from being worn out. In addition, the user feels better when directly touching the smooth flexible protection layer, compared to touching the uneven second textured membrane.

According to the invention, the first textured membrane includes one first texture layer and one first bearing layer that are stacked, where the first texture layer is disposed on a side, farther away from the housing body, of the first bearing layer. The structure is simple and easy to prepare.

Optionally, the first textured membrane includes a plurality of first texture layers and at least one first bearing layer that are stacked, where the first bearing layer is disposed between adjacent first texture layers. In this way, texture patterns of the first textured membrane are enriched, creating a better visual effect for users.

According to the invention, the second textured membrane includes one second texture layer and one flexible second bearing layer that are stacked, where the second texture layer is disposed on a side, farther away from the housing body, of the second bearing layer. The structure is simple and easy to prepare.

Optionally, the second textured membrane includes a plurality of second texture layers and at least one flexible second bearing layer that are stacked, where the second bearing layer is disposed between adjacent second texture layers. In this way, texture patterns of the second textured membrane are enriched, creating a better visual effect for users.

The first textured membrane includes one first texture layer, and the second textured membrane includes one second texture layer and one flexible second bearing layer that are stacked; and the second texture layer is disposed closer to the outer surface of the housing, and the first texture layer is disposed on a side, farther away from the second texture layer, of the second bearing layer. In this way, the number of bearing layers in the housing can be reduced, and the housing becomes lighter and thinner.

The housing body is located on a side, farther away from the second textured membrane, of the first textured membrane; optionally, the housing further includes a seventh transparent bonding layer; and the seventh transparent bonding layer is located between the first textured membrane and the housing body, and is used to bond the first textured membrane and the housing body. In this way, the number of transparent bonding layer in the housing can be reduced, and the housing becomes lighter and thinner.

The housing body is located on a side, farther away from the first textured membrane, of the second textured membrane; the housing body is a flexible structure; optionally, the housing further includes an eighth transparent bonding layer; and the eighth transparent bonding layer is located between the second textured membrane and the housing body, and is used to bond the second textured membrane and the housing body. In this way, the number of transparent bonding layer in the housing can be reduced, and the housing becomes lighter and thinner.

According to the invention, the flexible second textured membrane is able to deform in response to an external force. In this way, the housing can be prevented from being deformed as much as possible when it is not subjected to an external force, thereby preventing compression on internal components in the electronic device and impacts on performance of the internal components.

According to the invention, the first textured membrane is a flexible structure. The first textured membrane is also subject to deformation. Therefore, when the user applies external forces of different magnitudes to the housing, both the first textured membrane and the second textured membrane are deformed, so that a texture pattern is formed as a result of interference, thereby enriching the dynamic patterns and improving user experience.

The first textured membrane is able to deform in response to an external force. In this way, the housing can be prevented from being deformed as much as possible when it is not subjected to an external force, thereby preventing compression on internal components in the electronic device and impacts on performance of the internal components.

Optionally, that a texture pattern of the first texture layer is different from a texture pattern of the second texture layer is specifically: the texture pattern of the first texture layer is different from the texture pattern of the second texture layer in at least one of shape, size, arrangement, or placement angle.

The second textured membrane includes the second texture layer and the second bearing layer; optionally, the housing further includes a ribbon layer; and the ribbon layer is disposed on a surface, close to or far away from the housing body, of the second bearing layer. In this way, the housing is more colorful.

The first textured membrane includes the first texture layer and the first bearing layer; optionally, the housing further includes a ribbon layer; and the ribbon layer is disposed on a surface, close to or far away from the housing body, of the first bearing layer.

Optionally, the housing further includes a ribbon layer; and the ribbon layer is disposed on a surface, close to or far away from the second textured membrane, of the housing body.

According to a second aspect according to the invention, the invention provides an electronic device. The electronic device includes the housing according to any one of the first aspect; and the housing is a front housing or a rear housing of the electronic device.

### BRIEF DESCRIPTION OF DRAWINGS

FIG. 1 is a schematic structural diagram of an electronic device according to an embodiment of this application;
FIG. 2a is a stereogram of a housing according to an embodiment of this application;
FIG. 2b is a schematic cross-sectional view in a direction O1-O2 in FIG. 2a;
FIG. 2c is a partial enlarged view of FIG. 2b according to an embodiment of this application;
FIG. 2d is a stereogram of another housing according to an embodiment of this application;
FIG. 3a is a schematic top view of a first texture layer according to an embodiment of this application;
FIG. 3b is a schematic cross-sectional view in a direction A1-A2 in FIG. 3a;
FIG. 3c is a schematic top view of a second texture layer according to an embodiment of this application;
FIG. 3d is a schematic diagram of a superimposed effect of a first texture layer and a second texture layer according to an embodiment of this application;
FIG. 3e is another schematic diagram of a superimposed effect of a first texture layer and a second texture layer according to an embodiment of this application;
FIG. 3f is still another schematic diagram of a superimposed effect of a first texture layer and a second texture layer according to an embodiment of this application;
FIG. 3g is a schematic top view of another first texture layer according to an embodiment of this application;
FIG. 3h is a schematic top view of another second texture layer according to an embodiment of this application;
FIG. 3i is another schematic diagram of a superimposed effect of a first texture layer and a second texture layer according to an embodiment of this application;
FIG. 4a is a diagram of optical paths in a housing according to an embodiment of this application;
FIG. 4b is a diagram of optical paths in a housing on which external force is applied according to an embodiment of this application;
FIG. 5a to FIG. 5c are stacking structure diagrams of another housing according to an embodiment of this application;
FIG. 6a to FIG. 6e are stacking structure diagrams of still another housing according to an embodiment of this application;
FIG. 7a to FIG. 7f are stacking structure diagrams of still another housing according to an embodiment of this application;
FIG. 8a and FIG. 8b are stacking structure diagrams of still another housing according to an embodiment of this application;
FIG. 9 is a stacking structure diagram of still another housing according to an embodiment of this application;
FIG. 10a and FIG. 10b are stacking structure diagrams of still another housing according to an embodiment of this application; and
FIG. 11a to FIG. 11c are stacking structure diagrams of still another housing according to an embodiment of this application.

### Reference signs:

01. electronic device; 10. front housing; 20. display module; 30. middle frame; 40. housing; 41. first textured membrane; 411. first texture pattern; 4111. boss of first texture pattern; 4112. groove of first texture pattern; 412. first bearing layer; 413. first interlayer bonding layer; 42. second textured membrane; 421. second texture pattern; 4211. boss of second texture pattern; 4212. groove of second texture pattern; 422. second bearing layer; 423. second interlayer bonding layer; 43. housing body; 44. first bonding layer; 45. second bonding layer; 46. flexible protection layer; 47. ribbon layer; 48. metal plating layer; 49. ink layer; 50. rear housing; 53. third transparent bonding layer; 54. fourth transparent bonding layer; 55. fifth transparent bonding layer; 56. sixth transparent bonding layer; 57. seventh transparent bonding layer; and 58. eighth transparent bonding layer.

### DESCRIPTION OF EMBODIMENTS

The following describes the technical solutions in the embodiments of this application with reference to the accompanying drawings in the embodiments of this application. Apparently, the described embodiments are merely some but not all of the embodiments of this application.

In addition, the terms such as "first" and "second" are merely intended for a purpose of description, and shall not be understood as an indication or implication of relative importance or an implicit indication of the number of the indicated technical features. Therefore, a feature limited by "first", "second", or the like may explicitly or implicitly include one or more features.

In addition, in this application, the orientation terms such as "upper", "lower", "left", and "right" are defined with respect to the schematic orientation of the accompanying drawings. It should be understood that these directional terms are relative concepts, are used in relative description and clarification, and may correspondingly change according to the change of the placed orientation of the components.

An embodiment of this application provides an electronic device. The electronic device in this embodiment of this application may be, for example, a tablet computer, a mobile phone, an e-reader, a remote control, a personal computer (Personal Computer, PC), a notebook computer, and a personal digital assistant (personal digital assistant, PDA), an in-vehicle device, a web television, a wearable device, or a television. The embodiments of this application do not impose special restrictions on the specific form of the electronic device. For ease of description, the following provides description by using an example in which the electronic device is a mobile phone.

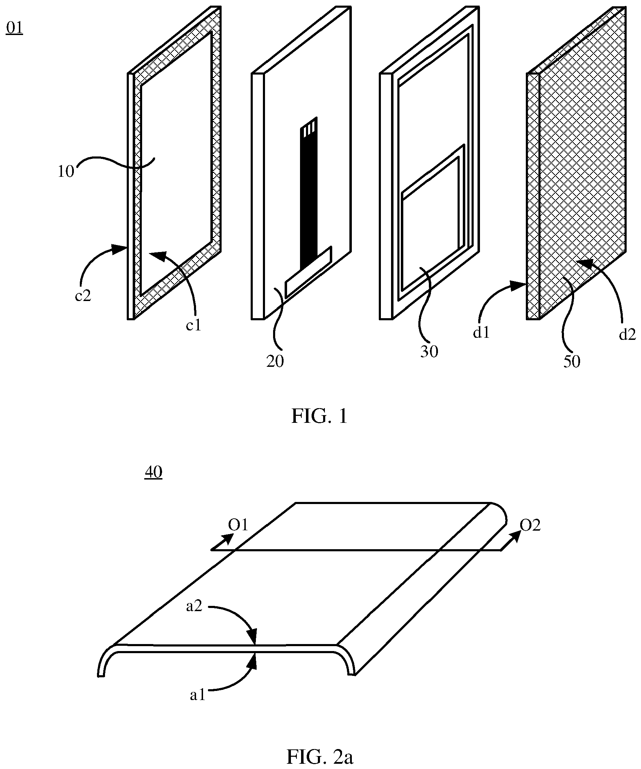

As shown in FIG. 1, the electronic device 01 mainly includes: a front housing 10, a display module 20, a middle frame 30, and a rear housing (or referred to as a battery cover) 50.

The display module 20 has a light-emitting side from which a display image can be seen and a rear face disposed opposite the light-emitting side.

The front housing 10 is located on the light-emitting side of the display module 20, and is configured to protect the display module 20. The front housing 10 may be, for example, cover glass (cover glass, CG), and the cover glass may have a toughness. The front housing 10 has an inner surface c1 and an outer surface c2 that are disposed back to back. The inner surface c1 of the front housing 10 faces the display module 20, and the outer surface c2 of the front housing 10 is back away from the display module 20. When touching the front of the electronic device 01, a user directly touches the outer surface c2 of the front housing 10.

The middle frame 30 is located between the display module 20 and the rear housing 50. A surface of the middle frame 30 away from the display module 20 is used to install internal components such as a battery, a mainboard, a camera (Camera), and an antenna.

The rear housing 50 is installed on the middle frame 30, and the rear housing 50 can protect the internal components of the electronic device 01. The rear housing 50 has an inner surface d1 and an outer surface d2 that are disposed back to back. The inner surface d1 of the rear housing 50 faces the middle frame 30, and the outer surface d2 of the rear housing 50 is back away from the middle frame. When touching the back of the electronic device 01, the user directly touches the outer surface d2 of the rear housing 50.

The display module 20 includes a display panel (display panel, DP).

In some embodiments of this application, the display panel may be a liquid crystal display (liquid crystal display, LCD). In this case, the display module 20 further includes a back light unit (back light unit, BLU) for providing a light source to the liquid crystal display.

In some other embodiments of this application, the display panel is an organic light emitting diode (organic light emitting diode, OLED) display. In this case, no back light unit needs to be configured.

An embodiment of this application provides a housing. The housing provided in this embodiment of this application may be a front housing 10 or a rear housing 50 of the electronic device 01. As shown in FIG. 2a, the following illustrate a structure of the housing in detail by using an example in which the housing 40 is the rear housing of the foregoing electronic device.

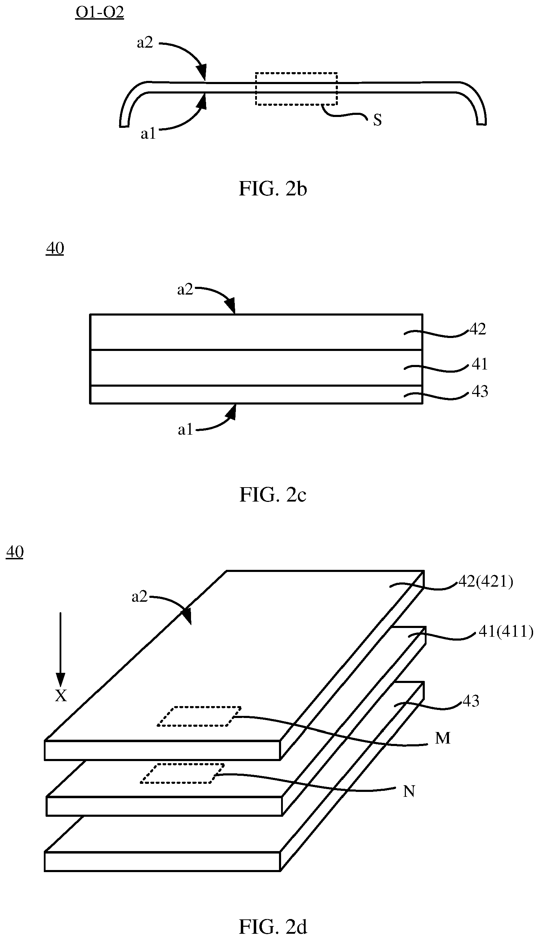

FIG. 2b (a cross-sectional view in a direction O1-O2 in FIG. 2a) is a cross-sectional view of the housing 40 according to this embodiment of this application. After the housing shown in FIG. 2b is applied to the electronic device 01 shown in FIG. 1, an inner surface a1 of the housing 40 faces the middle frame 30.

As shown in FIG. 2c (a partial enlarged view of the housing 40 in an area S shown in FIG. 2b), the housing 40 includes a housing body 43, a first textured membrane 41, and a flexible second textured membrane 42 that are stacked.

Herein, a relative positional relationship of the housing body 43, the first textured membrane 41, and the second textured membrane 42 is not limited, and the three are only required to be stacked. Regardless of the stacking arrangement, compared to a side close to the first textured membrane 41, a side, far away from the first textured membrane 41, of the second textured membrane 42 is always closer to an outer surface a2 of the housing 40. Certainly, it can be understood that as shown in FIG. 2c, in a case that no other membrane layer is provided on the side of the second textured membrane 42 far away from the first textured membrane 41, a surface of the second textured membrane 42 far away from the first textured membrane 41 is the outer surface a2 of the housing 40.

It should be understood that in a case that the housing 40 is the front housing 10 of the foregoing electronic device 01, the outer surface a2 of the housing 40 is the outer surface c2 of the front housing 10, and the inner surface a1 of the housing 40 is the inner surface c1 of the front housing 10. In a case that the housing 40 is the rear housing 50 of the foregoing electronic device 01, the outer surface a2 of the housing 40 is the outer surface d2 of the rear housing 50, and the inner surface a1 of the housing 40 is the inner surface d1 of the rear housing 50.

The housing body 43, the first textured membrane 41, and the second textured membrane 42 are all translucent membrane layers.

It should be noted that the second textured membrane 42 is flexible, which means that the second textured membrane 42 is slightly deformed under the action of external forces such as tension and pressure applied by a user. That is, the second textured membrane 42 is flexible, or deformable, so that the second textured membrane is able to deform in response to an external force.

According to the claimed invention, the first textured membrane 41 is a flexible structure (or referred to as a deformable structure), or, in an example outside the scope of the invention as claimed, may be a rigid structure. Since the first textured membrane 41 is a flexible structure, the first textured membrane 41 is used to deform in response to an external force. The flexible structure is a structure that is able to deform in response to an external force. In other words, the first textured membrane 41 is flexible and deformable like the second textured membrane 42.

FIG. 2d shows three-dimensional structures of the stacked housing body 43, first textured membrane 41, and second textured membrane 42 shown in FIG. 2c. The first textured membrane 41 includes at least one first texture layer 411 (in FIG. 2d, for example, the first textured membrane 41 includes one first texture layer 411). The second textured membrane 42 includes at least one second texture layer 421 (in FIG. 2d, for example, the second textured membrane 42 includes one second texture layer 421).

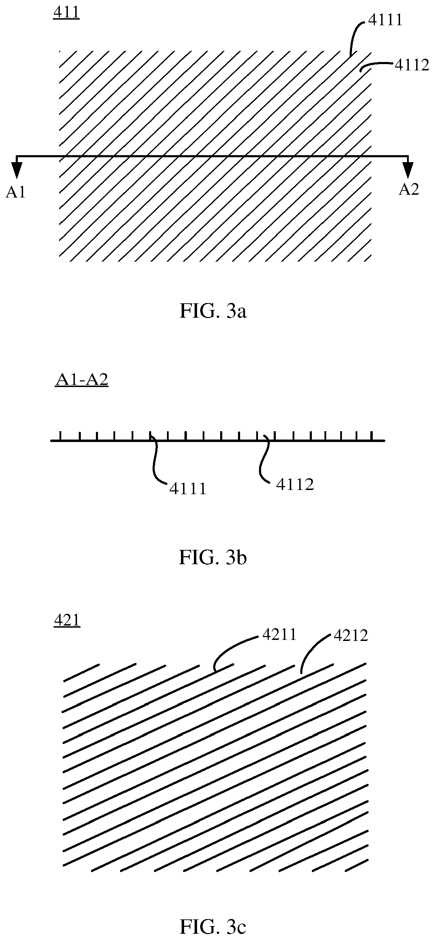

A top view of the first texture layer 411 and the second texture layer 421 can be obtained when looking down along a direction X shown in FIG. 2d. As shown in FIG. 3a (a top view of the partial enlarged view of the first texture layer 411 at position M shown in FIG. 2d) and FIG. 3b (a cross-sectional view in a direction A1-A2 in FIG. 3a), the first texture layer 411 includes a plurality of bosses 4111, and grooves 4112 between adjacent bosses 4111, to form a texture pattern of the first texture layer 411. Sizes of the boss 4111 and the groove 4112 may be nanoscale.

As shown in FIG. 3c (a top view of the partial enlarged view of the second texture layer 421 at position N shown in FIG. 2d), the second texture layer 421 includes a plurality of bosses 4211, and grooves 4212 between adjacent bosses 4211, to form a texture pattern of the second texture layer 421.

According to the claimed invention, the texture pattern of the first texture layer 411 is different from the texture pattern of the second texture layer 421.

That the texture pattern of the first texture layer 411 is different from the texture pattern of the second texture layer 421 means: the texture pattern of the first texture layer 411 is different from the texture pattern of the second texture layer 421 in one or more of shape, size, arrangement, or placement angle. For example, in FIG. 3a and FIG. 3c, the groove 4112 or the boss 4111 in the first texture layer 411 is different from the groove 4212 or the boss 4211 in the second texture layer 421. That the grooves or the bosses are different may be that the grooves or the bosses are different in one or more of shape, size, arrangement, or placement angle.

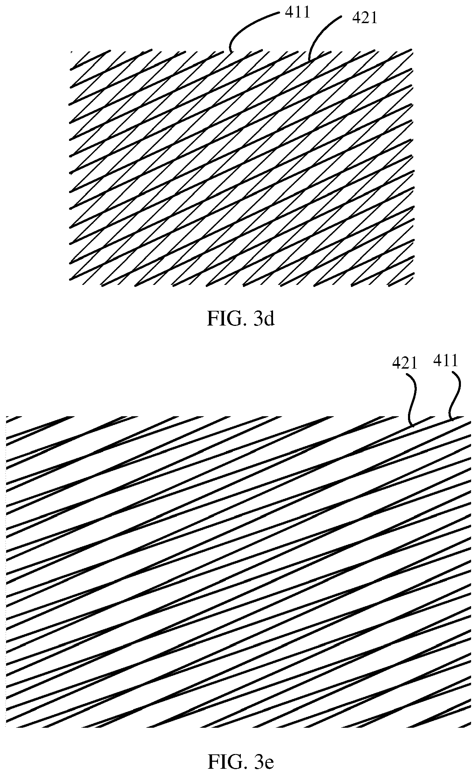

As shown in FIG. 3d, based on the principle of Moire fringe interference, after the first texture layer 411 shown in FIG. 3a and the second texture layer 421 shown in FIG. 3c are superimposed, an interference fringe is likely to appear. The interference fringe serves as a new texture pattern, and the new texture pattern is different from the texture patterns of the first texture layer 411 and the second texture layer 421.

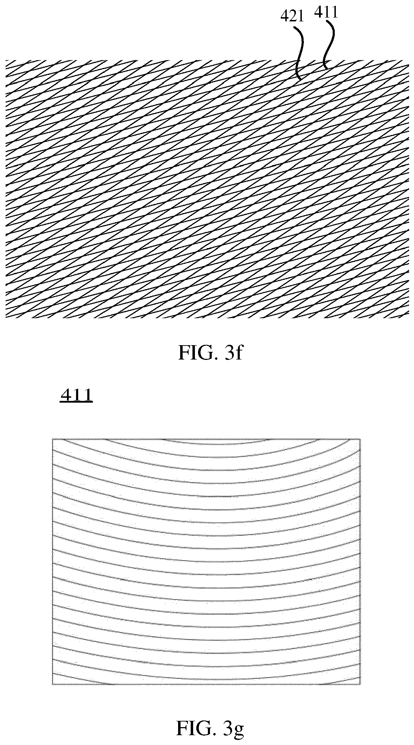

As shown in FIG. 3e and FIG. 3f, although the bosses in the first texture layer 411 and the second texture layer 421 in FIG. 3e and FIG. 3f are all strips, sizes and angles of the bosses are different, and new texture patterns formed after superimposition are also different.

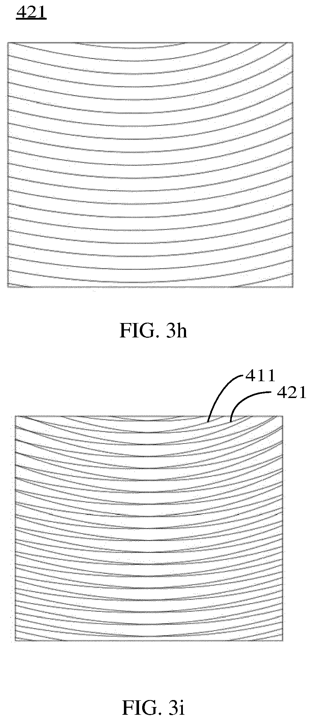

The embodiments of this application do not limit the texture patterns of the first texture layer 411 and the second texture layer 421. As shown in FIG. 3g (a top view of the partial enlarged view of the first texture layer 411 at position M shown in FIG. 2d) and FIG. 3h (a top view of the partial enlarged view of the second texture layer 421 at position N shown in FIG. 2d), the bosses in the first texture layer 411 and the second texture layer 421 may be curve-shaped, for example, crescent-shaped. FIG. 3i shows a new texture pattern formed by superimposing the first texture layer 411 in FIG. 3g and the second texture layer 421 in FIG. 3h.

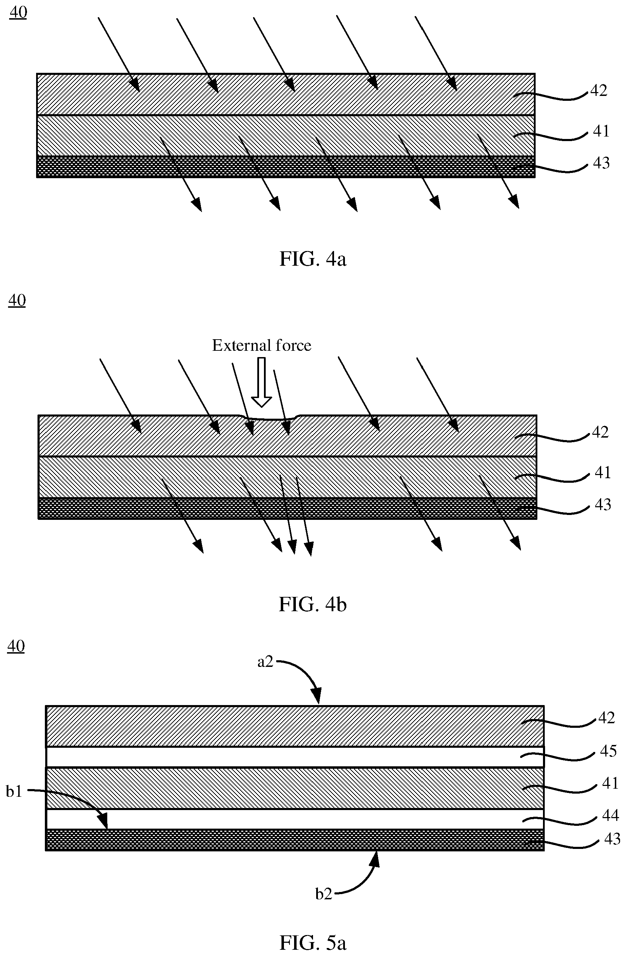

In a case that the first texture layer 411 has a structure shown in FIG. 3a and the second texture layer 421 has a structure shown in FIG. 3c, as shown in FIG. 4a (a partial enlarged view of the housing 40 in an area S shown in FIG. 2b), during normal use, after ambient light is irradiated on the housing 40, a texture pattern shown in FIG. 3d is formed. As shown in FIG. 4b, after a user presses the housing 40 or slides a finger on the housing 40 to apply an external force to the housing 40, the flexible second textured membrane 42 is deformed, causing a thickness and a texture pattern of the second textured membrane 42 at the pressed position to change, which in turn changes a refraction angle of light rays. As a result, an interference effect of the first texture layer 411 and the second texture layer 421 is changed, thereby presenting a dynamic texture effect, and enabling an appearance effect of the housing 40 to change dynamically with the user's gesture. A texture effect at a position pressed by the user presses is different from that at a position not pressed, and the texture effect also varies with intensity of the pressing force, so that the appearance effect of the housing 40 can dynamically change with the pressing of the user.

The following describes a structure of the housing 40 provided in the embodiments of this application by using several specific examples.

### Example 1

In this example, the first textured membrane 41 and the second textured membrane 42 are arranged on a same side of the housing body 43, and the side on which the first textured membrane 41 and the second textured membrane 42 are arranged serves as the outer surface a2 of the housing 40.

As shown in FIG. 5a (a partial enlarged view of the housing 40 in an area S shown in FIG. 2b), the housing 40 includes a housing body 43, a first textured membrane 41, and a flexible second textured membrane 42 that are stacked.

The housing body 43 has a first surface b1 and a second surface b2 that are opposite each other, both the first textured membrane 41 and the second textured membrane 42 are disposed on the first surface b1 of the housing body 43, and the first textured membrane 41 is disposed closer to the housing body 43 relative to the second textured membrane 42.

After the housing 40 is applied to the electronic device 01, the second surface b2 of the housing body 43 faces the middle frame 30 of the electronic device 01. The first surface b1 of the housing body 43 on which the first textured membrane 41 and the second textured membrane 42 are arranged is back away from the middle frame 30. A side, farther away from the first textured membrane 41, of the second textured membrane 42 serves as the outer surface a2 of the housing 40 and is subject to direct touch by the user.

In this example, the housing body 43 may be a rigid transparent or translucent body, such as a glass body (such as 2D glass or 3D glass); or a resin body with a same or similar hardness as the glass body; or a body made from a transparent or translucent inorganic material, such as ceramics or sapphire. The housing body 43 may alternatively be a soft transparent or translucent body, such as a polymethyl methacrylate (polymethyl methacrylate, PMMA) body; or a polycarbonate (polycarbonate, PC) body; or a composite sheet body of a PC film and a PMMA film that are laminated.

On this basis, as shown in FIG. 5a, the housing 40 may further include a first transparent bonding layer 44 and a second transparent bonding layer 45.

The first transparent bonding layer 44 is located between the first textured membrane 41 and the housing body 43, and is used to bond the first textured membrane 41 and the housing body 43. The second transparent bonding layer 45 is located between the first textured membrane 41 and the second textured membrane 42, and is used to bond the first textured membrane 41 and the second textured membrane 42.

A material of the first transparent bonding layer 44 and the second transparent bonding layer 45 may be for example, optically clear adhesive (optically clear adhesive, OCA), and a thickness may be 15 µm to 30 µm, for example, 20 µm or 25 µm.

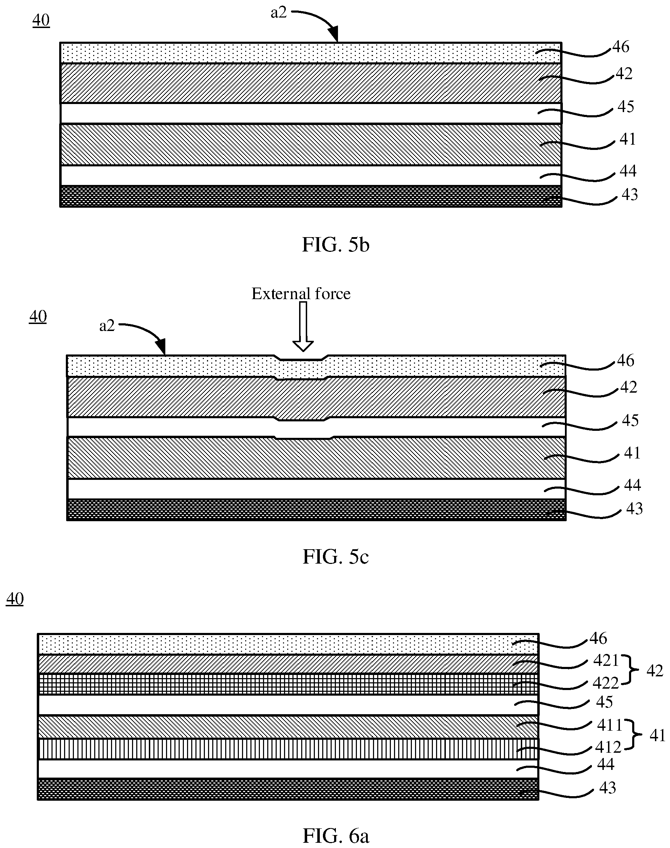

In some embodiments, as shown in FIG. 5b (a partial enlarged view of the housing 40 in an area S shown in FIG. 2b), the housing 40 may further include a flexible protection layer 46, where the flexible protection layer 46 is disposed on a side, farther away from the housing body 43, of the second textured membrane 42.

In other words, a surface of the flexible protection layer 46 farther away from the second textured membrane 42 serves as the outer surface a2 of the housing 40.

A material of the flexible protection layer 46 may be, for example, a transparent material such as polyethylene terephthalate (polyethylene terephthalate, PET), polyphenylene oxide (polyphenylene oxide, PPO), or thermoplastic polyurethane (thermoplastic polyurethanes, TPU). Certainly, to improve anti-scratch performance of the flexible protection layer 46, the material of the flexible protection layer 46 may be a bit harder, as long as it can be deformed when being pressed.

The flexible protection layer 46 may be, for example, bonded to the side of the second textured membrane 42 farther away from the first textured membrane 41 through a bonding layer after the second textured membrane 42 is bonded to the housing body 43. Alternatively, the flexible protection layer 46 may be formed on the second textured membrane 42 through an injection molding process, and then the second textured membrane 42 with the flexible protection layer 46 formed is bonded to the housing body 43.

The flexible protection layer 46 can protect the second textured membrane 42, preventing the second textured membrane 42 from being worn out. In addition, the user feels better when directly touching the smooth flexible protection layer 46, compared to touching the uneven second textured membrane 42.

The following describes structures of the first textured membrane 41 and the second textured membrane 42 by using examples.

In some embodiments, as shown in FIG. 6a (a partial enlarged view of the housing 40 in an area S shown in FIG. 2b), the first textured membrane 41 includes one first texture layer 411 and one first bearing layer 412, and the first texture layer 411 is disposed on a side, farther away from the housing body 43, of the first bearing layer 412.

The second textured membrane 42 includes one second texture layer 421 and one flexible second bearing layer 422 that are stacked, and the second texture layer 421 is disposed on a side, farther away from the housing body 43, of the second bearing layer 422.

The first bearing layer 412 may be a flexible film layer or a hard film layer. In some embodiments, the first bearing layer 412 is a flexible film layer. For example, a material of the first bearing layer 412 is the same as that of the flexible protection layer 46. In this way, the first textured membrane 41 is also subject to deformation. Therefore, when the user applies external forces of different magnitudes to the housing 40, both the first textured membrane 41 and the second textured membrane 42 are deformed, so that a texture pattern is formed as a result of interference, thereby enriching the dynamic patterns and improving user experience.

A material of the second bearing layer 422 may also be the same as that of the flexible protection layer 46. A thickness of each of the first bearing layer 412 and the second bearing layer 422 may be 30 µm to 70 µm, for example, 40 µm, 50 µm, or 60 µm.

In addition, the first texture layer 411, for example, may have UV (ultra violet, ultra violet) adhesive transfer-printed to the first bearing layer 412 by using a UV transfer printing technology, to prepare the first texture layer 411. Similarly, the second texture layer 421 may also be prepared by using UV transfer printing technology.

In this case, as shown in FIG. 6a, the first transparent bonding layer 44 is located between the first bearing layer 412 and the housing body 43, and is used to bond the first bearing layer 412 and the housing body 43, so that the first textured membrane 41 is bonded to the housing body 43. The second transparent bonding layer 45 is located between the first texture layer 411 and the second bearing layer 422, and is used to bond the first texture layer 411 and the second bearing layer 422, so that the second textured membrane 42 is bonded onto the first textured membrane 41.

It can be understood that, the first texture layer 411 may be directly prepared on the first bearing layer 412, and the second texture layer 421 may be directly prepared on the second bearing layer 422. In this case, the second transparent bonding layer 45 is bonded to the first bearing layer 412 and the second bearing layer 422 that are arranged with the first texture layer 411 and the second texture layer 421, respectively.

In such structure, when the first texture layer 411 is being prepared, the first texture layer 411 may be formed on the first bearing layer 412 to which the first transparent bonding layer 44 is bonded. It can also be understood as that after the first bearing layer 412 and the first transparent bonding layer 44 are integrally processed, the first texture layer 411 is formed. Similarly, after the second bearing layer 422 and the second transparent bonding layer 44 are integrally processed, the second texture layer 421 is formed. Finally, the first transparent bonding layer 44 is bonded to the housing body 43, and the second transparent bonding layer 45 is bonded to the first texture layer 411.

Therefore, in the housing 40 shown in FIG. 6a, the processing requirements for separately bonding the first textured membrane 41 and the second textured membrane 42 to the housing body 43 are not high. The preparation process is simple, and the production efficiency is high.

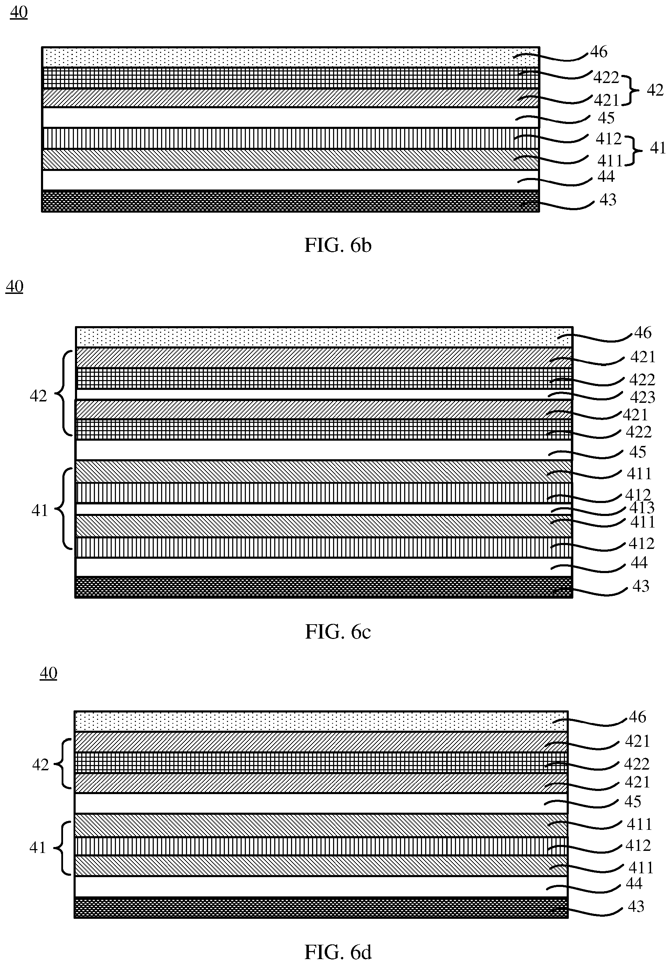

In some other embodiments, as shown in FIG. 6b (a partial enlarged view of the housing 40 in the area S shown in FIG. 2b), the first textured membrane 41 includes one first texture layer 411 and one first bearing layer 412 that are stacked, and the first texture layer 411 are disposed on a side, closer to the housing body 43, of the first bearing layer 412. The second textured membrane 42 includes one second texture layer 421 and one flexible second bearing layer 422 that are stacked, and the second texture layer 421 is disposed on a side, closer to the housing body 43, of the second bearing layer 422.

In this case, as shown in FIG. 6b, the first transparent bonding layer 44 is located between the first textured membrane 41 and the housing body 43, and is used to bond the first textured membrane 41 to the housing body 43, so that the first textured membrane 41 is bonded to the housing body 43. The second transparent bonding layer 45 is located between the first bearing layer 412 and the second texture layer 421, and is used to bond the first bearing layer 412 and the second texture layer 421, so that the second textured membrane 42 is bonded onto the first textured membrane 41.

In some other embodiments, the first textured membrane 41 includes a plurality of first texture layers 411 and at least one first bearing layer 412 that are stacked, and the first bearing layer 412 is disposed between adjacent first texture layers 411. The second textured membrane 42 includes a plurality of second texture layers 421 and at least one flexible second bearing layer 422 that are stacked, and the second bearing layer 422 is provided between adjacent second texture layers 421.

In an example, as shown in FIG. 6c (a partial enlarged view of the housing 40 in the area S shown in FIG. 2b), the first textured membrane 41 includes a plurality of first texture layers 411 and a plurality of first bearing layers 412 that are stacked. One first texture layer 411 is provided on a side, farther away from the housing body 43, of each first bearing layer 412. A first interlayer bonding layer 413 is disposed between the first texture layer 411 and the first bearing layer 412 that is adjacent to the first texture layer 411 and located on a side, farther away from the housing body 43, of the first texture layer 411.

Texture patterns of any two of the plurality of first texture layers 411 may be the same or different; or some of the texture patterns are the same, and some of the texture patterns are different.

The second textured membrane 42 includes a plurality of second texture layers 421 and a plurality of flexible second bearing layers 422 that are stacked. One second texture layer 421 is disposed on a side, farther away from the housing body 43, of each second bearing layer 422. A second interlayer bonding layer 423 is disposed between the second texture layer 421 and the second bearing layer 422 that is adjacent to the second texture layer 421 and located on a side, farther away from the housing body 43, of the second texture layer 421.

Similarly, in some embodiments, the texture patterns of the plurality of second texture layers 421 are completely the same, or not completely the same, or totally different.

Each first textured membrane 41 includes a plurality of first texture layers 411 with different texture patterns, and the second textured membrane 42 includes a plurality of second texture layers 421 with different texture patterns, so that a new texture pattern formed by interference of the first textured membrane 41 and the second textured membrane 42 is complicated, which makes the texture pattern difficult to be copied and simulated, thereby reducing the degree of homogeneity of the product.

In another example, as shown in FIG. 6d (a partial enlarged view of the housing 40 in the area S shown in FIG. 2b), the first textured membrane 41 includes two first texture layers 411 and one first bearing layer 412 that are stacked, and one first texture layer 411 is separately disposed on a side of the first bearing layer 412 closer to the housing body 43 and a side farther away from the housing body 43. Texture patterns of the two first texture layers 411 are different. The second textured membrane 42 includes two second texture layers 421 and a flexible second bearing layer 422 that are stacked, and one second texture layer 421 is separately disposed on a side of the second bearing layer 422 closer to the housing body 43 and a side farther away from the housing body 43. Texture patterns of the two second texture layers 421 are different. In this way, the number of film layers in the housing 40 can be reduced, making the housing 40 lighter and thinner.

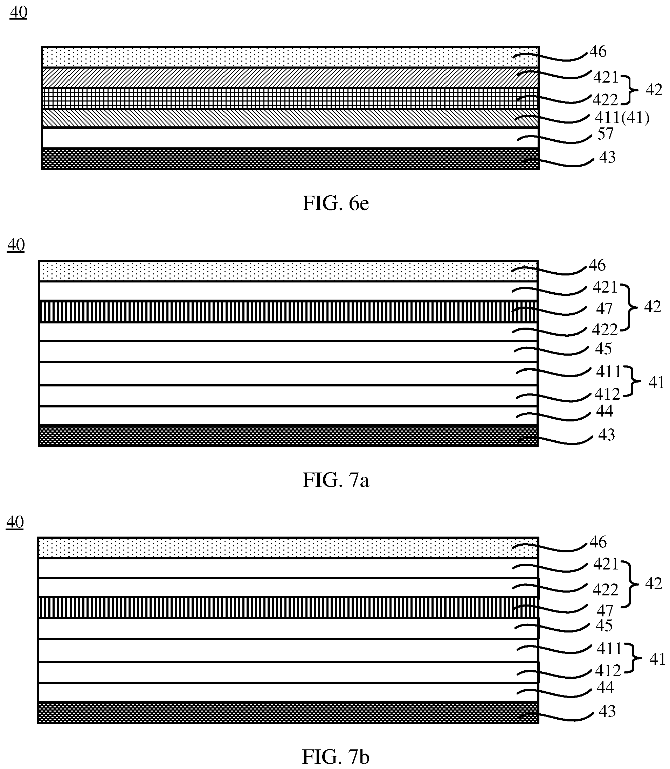

In some other embodiments, as shown in FIG. 6e (a partial enlarged view of the housing 40 in the area S shown in FIG. 2b), the second textured membrane 42 includes one second texture layer 421 and one flexible second bearing layer 422 that are stacked, and the second texture layer 421 is disposed on a side, farther away from the housing body 43, of the second bearing layer 422. The first textured membrane 41 includes one first texture layer 411, and the first texture layer 411 is disposed on a side, farther away from the second texture layer 421, of the second bearing layer 422.

The second texture layer 421 is disposed on a side, farther away from the housing body 43, of the second bearing layer 422, that is, the second texture layer 421 is disposed on a side of the second bearing layer 422 closer to the outer surface a2 of the housing 40.

It should be noted that in the housing 40 shown in FIG. 6e, because the first texture layer 411 is directly formed on the side of the second bearing layer 422 closer to the housing body 43, which is equivalent that the second texture layer 421 and the first texture layer 411 share the second bearing layer 422, the first bearing layer 412 for bearing the first texture layer 411 does not need to be provided separately.

Therefore, as shown in FIG. 6e, only one seventh transparent bonding layer 57 needs to be disposed in the housing 40, where the seventh transparent bonding layer 57 is located between the first textured membrane 41 and the housing body 43, and is used to bond the first texture layer 411 in the first textured membrane 41 and the housing body 43.

In this way, the number of film layers in the housing 40 can be reduced, making the housing 40 lighter and thinner. On the basis of the foregoing embodiments, to enrich colors of the housing 40, the housing 40 further includes a ribbon layer 47.

The following describes a position of the ribbon layer 47 in the housing 40 by using the housing 40 shown in FIG. 6a as an example. It should be noted that, in other embodiments, the ribbon layer 47 may also be disposed at different positions in the similar way.

In some embodiments, as shown in FIG. 7a (a partial enlarged view of the housing 40 in the area S shown in FIG. 2b), the ribbon layer 47 is disposed on a side, farther away from the housing body 43, of the second bearing layer 422.

For example, a ribbon layer 47 may be formed through an offset printing process on a surface, farther away from the housing body 43, of the second bearing layer 422. The ribbon layer 47 may be a pure color film layer containing only one color, or a gradient color film layer containing a plurality of colors.

In this case, as shown in FIG. 7a, the ribbon layer 47 is located between the second texture layer 421 and the second bearing layer 422, and the ribbon layer 47 belongs to the second textured membrane 42.

In some other embodiments, as shown in FIG. 7b (a partial enlarged view of the housing 40 in the area S shown in FIG. 2b), the ribbon layer 47 is disposed on a surface, closer to the housing body 43, of the second bearing layer 422. In this case, the ribbon layer 47 is located between the second bearing layer 422 and the second transparent bonding layer 45, and the ribbon layer 47 belongs to the second textured membrane 42.

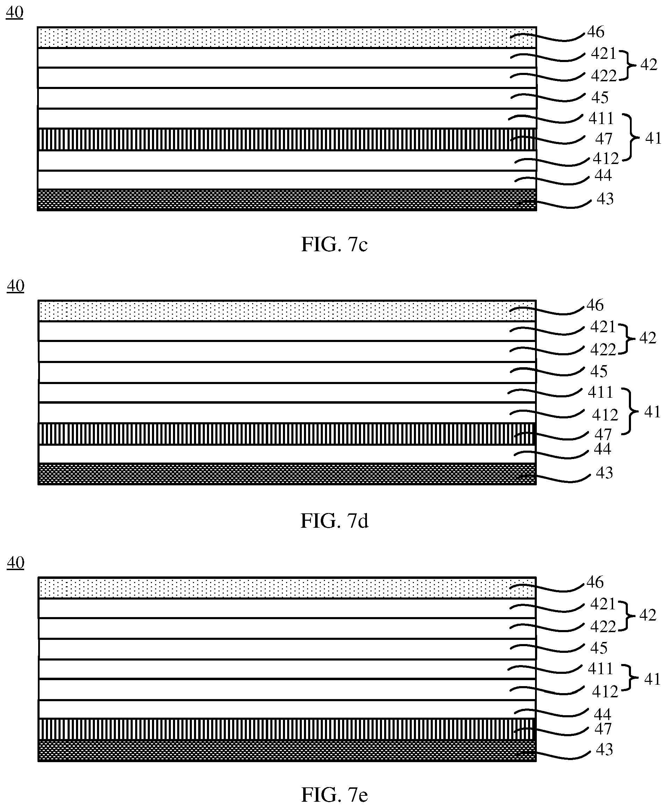

In some other embodiments, as shown in FIG. 7c (a partial enlarged view of the housing 40 in the area S shown in FIG. 2b), the ribbon layer 47 is disposed on a surface, farther away from the housing body 43, of the first bearing layer 412. In this case, the ribbon layer 47 is located between the first texture layer 411 and the first bearing layer 412, and the ribbon layer 47 belongs to the first textured membrane 41.

In some other embodiments, as shown in FIG. 7d (a partial enlarged view of the housing 40 in the area S shown in FIG. 2b), the ribbon layer 47 is disposed on a surface, closer to the housing body 43, of the first bearing layer 412. In this case, the ribbon layer 47 is located between the first bearing layer 412 and the first transparent bonding layer 44, and the ribbon layer 47 belongs to the first textured membrane 41.

In some other embodiments, as shown in FIG. 7e (a partial enlarged view of the housing 40 in the area S shown in FIG. 2b), the ribbon layer 47 is disposed on a surface, closer to the first textured membrane 41, of the housing body 43.

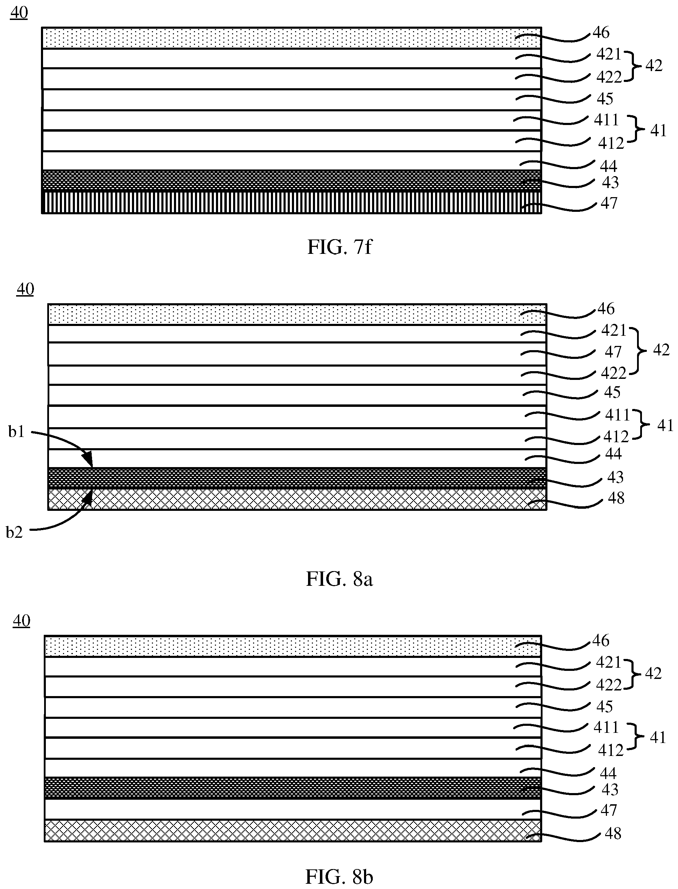

In some other embodiments, as shown in FIG. 7f (a partial enlarged view of the housing 40 in the area S shown in FIG. 2b), the ribbon layer 47 is disposed on a surface, farther away from the first textured membrane 41, of the housing body 43.

On this basis, as shown in FIG. 8a (a partial enlarged view of the housing 40 in the area S shown in FIG. 2b), the housing 40 further includes a metal plating layer 48 disposed on a side, farther away from the first textured membrane 41, of the housing body 43. FIG. 8a illustrates the housing 40 shown in FIG. 7a as an example. It should be noted that, in other embodiments, the metal plating layer 48 may also be disposed at different positions in the similar way.

In other words, the metal plating layer 48 is disposed on a side on which the second surface b2 of the housing body 43 is located. The metal plating layer 48 may be, for example, a non-conductive coating formed by using a non-conductive vacuum metalize (non-conductive vacuum metalize, NCVM) technology.

It should be understood that, as shown in FIG. 8b (a partial enlarged view of the housing 40 in the area S shown in FIG. 2b), if the side on which the second surface b2 of the housing body 43 is located is also provided with a ribbon layer 47, the metal plating layer 48 is located on a side of the ribbon layer 47 farther away from the housing body 43.

The metal plating layer 48 can reflect light, thereby making the colors of the ribbon layer 47 brighter.

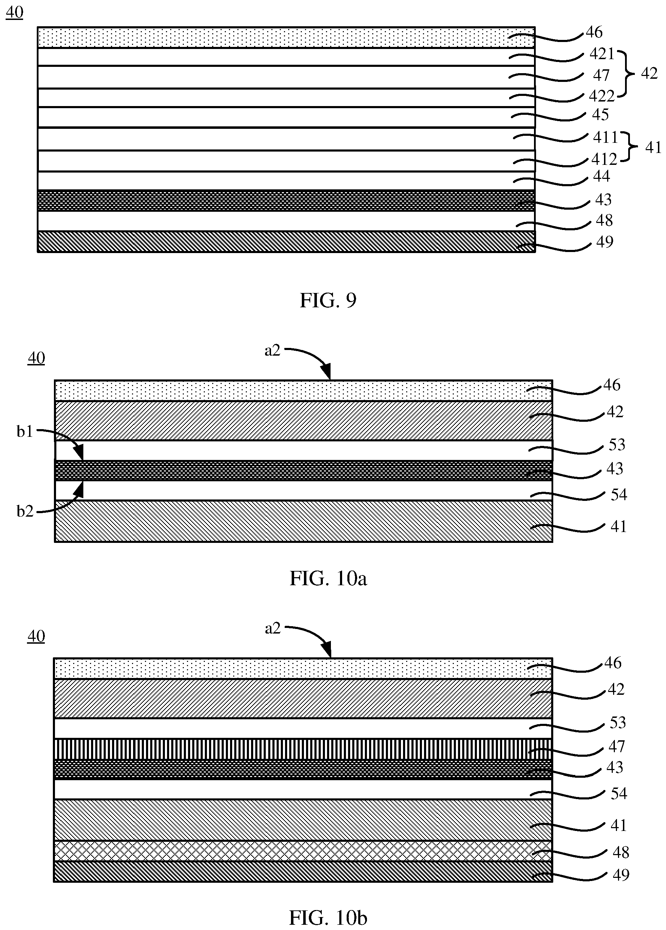

On this basis, as shown in FIG. 9 (a partial enlarged view of the housing 40 in the area S shown in FIG. 2b), the housing 40 further includes an ink layer 49 disposed on a side, farther away from the housing body 43, of the metal plating layer 48. In other words, the metal plating layer 48 and the ink layer 49 are stacked in sequence on a side, farther away from the first textured membrane 41, of the housing body 43.

For example, the ink layer 49 can be formed through a screen printing process. The ink layer 49 has a function of shielding light, which can prevent the user from seeing internal components provided on the middle frame 30 of the electronic device 01 from the outer surface a2 of the housing 40.

In the housing 40 provided in this example, the flexible second textured membrane 42 may deform after being subjected to an external force, so that a new texture pattern formed after Moire fringe interference occurs between the first textured membrane 41 and the second textured membrane 42, achieving an effect that the appearance of the housing 40 dynamically changes with the user's gestures.

In addition, in a case that the first textured membrane 41 is also a flexible membrane and the second transparent bonding layer 45 located between the first textured membrane 41 and the second textured membrane 42 is a soft glue with fluidity such as OCA, as shown in FIG. 5c, after the user applies an external force to the outer surface a2 of the housing 40, the second textured membrane 42, the second transparent bonding layer 45, and the first textured membrane 41 can all be deformed. In this case, if the external force applied by the user is small, only the second textured membrane 42 is deformed, and a first type of new texture pattern is formed after Moire fringe interference occurs between the first textured membrane 41 and the second textured membrane 42. If the external force applied by the user is large, both the first textured membrane 41 and the second textured membrane 42 may be deformed, and a second type of new texture pattern is formed after Moire fringe interference occurs between the first textured membrane 41 and the second textured membrane 42. The second type of new texture pattern is different from the first type of new texture pattern, enriching appearance changes of the rear housing 40.

### Example 2

Example 2 differs from Example 1 in that the first textured membrane 41 and the second textured membrane 42 are respectively arranged on two sides of the housing body 43, and a side on which the second textured membrane 42 is disposed serves as the outer surface of the housing 40.

As shown in FIG. 10a (a partial enlarged view of the housing 40 in the area S shown in FIG. 2b), the housing 40 includes a housing body 43, a first textured membrane 41, a flexible second textured membrane 42, a third transparent bonding layer 53, a fourth transparent bonding layer 54, and a flexible protection layer 46 that are stacked.

The housing body 43 has a first surface b1 and a second surface b2 that are opposite each other, the first textured membrane 41 is disposed on the second surface b2, and the second textured membrane 42 is disposed on the first surface b1.

After the housing 40 is applied to the electronic device 01, the second surface b2 of the housing body 43 faces the middle frame 30 of the electronic device 01. The first surface b1 of the housing body 43 on which the second textured membrane 42 is disposed is back away from the middle frame 30. A side, farther away from the first textured membrane 41 (or the housing body 43), of the second textured membrane 42 serves as the outer surface a2 of the housing 40 and is subject to direct touch by the user.

A material of the housing body 43 in this example may be the same as a material of the housing body 43 illustrated in Example 1, and is not repeated herein. The structures of the first textured membrane 41 and the second textured membrane 42 may be the same as the structures in Example 1, and reference may be made to the description of the first textured membrane 41 and the second textured membrane 42 in Example 1.

The third transparent bonding layer 53 is located between the second textured membrane 42 and the housing body 43, and is used to bond the second textured membrane 42 and the housing body 43. The fourth transparent bonding layer 54 is located between the first textured membrane 41 and the housing body 43, and is used to bond the first textured membrane 41 and the housing body 43.

The structures of the third transparent bonding layer 53 and the fourth transparent bonding layer 54 may be the same as the structures of the first transparent bonding layer 44 and the second transparent bonding layer 45 in Example 1, and are not repeated herein.

The flexible protection layer 46 is disposed on a side, farther away from the housing body 43, of the second textured membrane 42. In other words, a surface of the flexible protection layer 46 farther away from the second textured membrane 42 serves as the outer surface a2 of the housing 40.

In some embodiments, as shown in FIG. 10b (a partial enlarged view of the housing 40 in the area S shown in FIG. 2b), the housing 40 further includes a ribbon layer 47. For a position of the ribbon layer 47 in the housing 40, reference may be made to description of the ribbon layer 47 in Example 1.

In some embodiments, as shown in FIG. 10b, the housing 40 further includes a metal plating layer 48 and an ink layer 49 that are arranged in sequence on a side, farther away from the housing body 43, of the first textured membrane 41.

In the housing 40 in this example, the first textured membrane 41 and the second textured membrane 42 are respectively arranged on two sides of the housing body 43. On a basis that a new texture pattern is formed after Moire fringe interference occurs between the first texture layer 411 and the second texture layer 421, a refraction effect of the housing body 43 on light rays (the housing body 43 is equivalent to a convex lens) can be used to achieve a depth of field display effect on the first texture layer 411 in the first textured membrane 41, creating a three-dimensional visual effect, and improving the visual effect of the housing 40.

### Example 3

Example 3 differs from Example 1 in that a side of the housing body 43 on which the first textured membrane 41 and the second textured membrane 42 are not disposed serves as the outer surface a2 of the housing 40, and that the housing 40 does not need to be provided with the flexible protection layer 46.

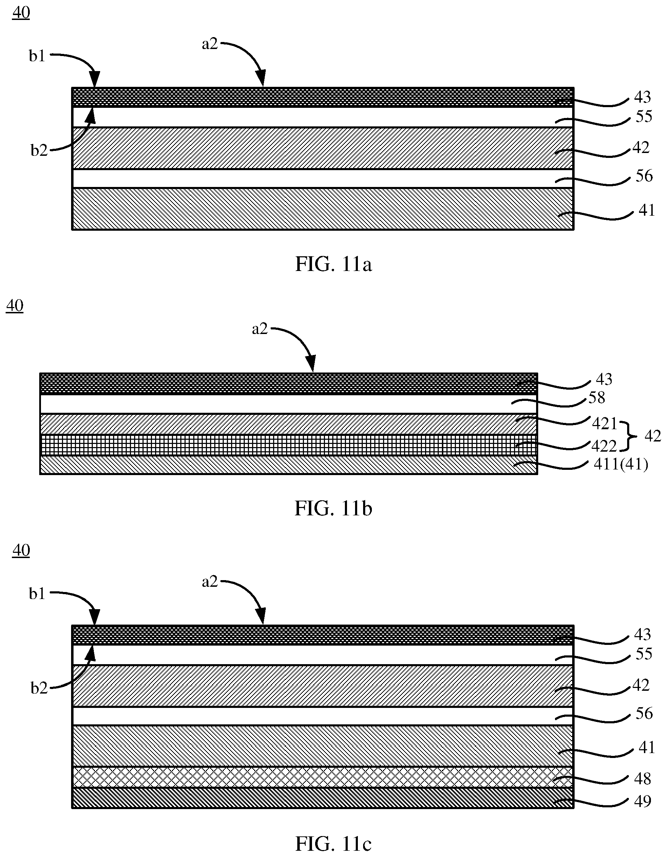

As shown in FIG. 11a (a partial enlarged view of the housing 40 in the area S shown in FIG. 2b), the housing 40 includes a housing body 43, a first textured membrane 41, a flexible second textured membrane 42, a fifth transparent bonding layer 55, and a sixth transparent bonding layer 56 that are stacked.

The housing body 43 has a first surface b1 and a second surface b2 that are opposite each other, both the first textured membrane 41 and the second textured membrane 42 are disposed on the second surface b2 of the housing body 43, and the first textured membrane 41 is disposed farther away from the housing body 43 relative to the second textured membrane 42.

After the housing 40 is applied to the electronic device 01, the second surface b2 of the housing body 43 on which the first textured membrane 41 and the second textured membrane 42 are disposed faces the middle frame 30 of the electronic device 01. The first surface b1 of the housing body 43 is back away from the middle frame 30. The first surface b1 of the housing body 43 serves as the outer surface a2 of the housing 40 and is subject to direct touch by the user.

In this example, the housing body 43 is a flexible structure, that is, a soft transparent or translucent body, such as a polymethyl methacrylate (polymethyl methacrylate, PMMA) body; or a polycarbonate (polycarbonate, PC) body; or a composite sheet body of a PC film and a PMMA film that are stacked.

In this example, the structures of the first textured membrane 41 and the second textured membrane 42 may be the same as the structures in Example 1, and reference may be made to the description of the first textured membrane 41 and the second textured membrane 42 in Example 1.

The fifth transparent bonding layer 55 is located between the second textured membrane 42 and the housing body 43, and is used to bond the second textured membrane 42 and the housing body 43. The sixth transparent bonding layer 56 is located between the second textured membrane 42 and the first textured membrane 41, and is used to bond the second textured membrane 42 and the first textured membrane 41.

It should be noted that, as shown in FIG. 11b (a partial enlarged view of the housing 40 in the area S shown in FIG. 2b), the second textured membrane 42 includes one second texture layer 421 and one flexible second bearing layer 422 that are stacked, and the second texture layer 421 is disposed on a side, closer to the housing body 43, of the second bearing layer 422. The first textured membrane 41 includes one first texture layer 411. In a case that the first texture layer 411 is disposed on a side, farther away from the second texture layer 421, of the second bearing layer 422, only one eighth transparent bonding layer 55 needs to be disposed in the housing 40, where the eighth transparent bonding layer 55 is located between the second textured membrane 42 and the housing body 43, and is used to bond the second texture layer 421 in the second textured membrane 42 and the housing body 43.

The second texture layer 421 is disposed on a side, closer to the housing body 43, of the second bearing layer 422, that is, the second texture layer 421 is disposed on a side of the second bearing layer 422 closer to the outer surface a2 of the housing 40.

In this way, the number of film layers in the housing 40 can be reduced, making the housing 40 lighter and thinner.

As shown in FIG. 11c (a partial enlarged view of the housing 40 in the area S shown in FIG. 2b), in some embodiments, the housing 40 further includes a metal plating layer 48 and an ink layer 49 that are disposed in sequence on a side, farther away from the second textured membrane 42, of the first textured membrane 41.

No flexible protection layer 36 needs to be provided in the housing 40 illustrated in this example, which can increase light transmittance and make the housing 40 thinner and lighter.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A housing (40), comprising:
a housing body (43), a first textured membrane (41), and a flexible second textured membrane (42) that are stacked, wherein a side, farther away from the first textured membrane (41), of the second textured membrane (42) is closer to an outer surface (a2) of the housing;
wherein the first textured membrane (41) comprises one first texture layer (411) and one first bearing layer (412) that are stacked, wherein the first texture layer (411) is disposed on a side, farther away from the housing body (43), of the first bearing layer (412);
wherein the second textured membrane (42) comprises one second texture layer (421) and one flexible second bearing layer (422) that are stacked, wherein the second texture layer (421) is disposed on a side, farther away from the housing body (43), of the second bearing layer (422);
a texture pattern of the first texture layer is different from a texture pattern of the second texture layer;
wherein the flexible second textured membrane (42) is able to deform in response to an external force; and
wherein the first textured membrane (41) is a flexible structure, and the first textured membrane (41) is able to deform in response to an external force.

2. The housing (40) according to claim 1, wherein the housing body (43) is located on a side, farther away from the second textured membrane (42), of the first textured membrane (41); and
the housing (40) further comprises a first transparent bonding layer (44) and a second transparent bonding layer (45), wherein
the first transparent bonding layer (44) is located between the first textured membrane (41) and the housing body (43), and is used to bond the first textured membrane (41) and the housing body (43); and
the second transparent bonding layer (45) is located between the first textured membrane (41) and the second textured membrane (42), and is used to bond the first textured membrane (41) and the second textured membrane (42).

3. The housing (40) according to claim 1, wherein the first textured membrane (41) and the second textured membrane (42) are respectively disposed on two opposite sides of the housing body (43); and
the housing (40) further comprises a third transparent bonding layer (53) and a fourth transparent bonding layer (54), wherein
the third transparent bonding layer (53) is located between the second textured membrane (42) and the housing body (43), and is used to bond the second textured membrane (42) and the housing body (43); and
the fourth transparent bonding layer (54) is located between the first textured membrane (41) and the housing body (43), and is used to bond the first textured membrane (41) and the housing body (43).

4. The housing (40) according to claim 1, wherein the housing body is located on a side, farther away from the first textured membrane (41), of the second textured membrane (42); the housing body (43) is a flexible structure; and
the housing (40) further comprises a fifth transparent bonding layer (55) and a sixth transparent bonding layer (56), wherein
the fifth transparent bonding layer (55) is located between the second textured membrane (42) and the housing body (43), and is used to bond the second textured membrane (42) and the housing body (43); and
the sixth transparent bonding layer (56) is located between the second textured membrane (42) and the first textured membrane (41), and is used to bond the second textured membrane (42) and the first textured membrane (41).

5. The housing (40) according to any one of claims 1 to 3, wherein the housing further comprises a flexible protection layer (46), wherein the flexible protection layer (46) is disposed on a side, farther away from the housing body (43), of the second textured membrane (42).

6. The housing (40) according to any one of claims 1 to 5, wherein that a texture pattern of the first texture layer (411) is different from a texture pattern of the second texture layer (421) is specifically: the texture pattern of the first texture layer (411) is different from the texture pattern of the second texture layer (421) in at least one of shape, size, arrangement, or placement angle.

7. The housing (40) according to any one of claims 1 to 6, wherein the housing (40) further comprises a ribbon layer (47), wherein
the ribbon layer (47) is disposed on a surface of the second bearing layer (422) closer to or farther away from the housing body (43);
or
the ribbon layer (47) is disposed on a surface of the first bearing layer (412) closer to or farther away from the housing body (43);
or
the ribbon layer (47) is disposed on a surface of the housing body (43) closer to or farther away from the second textured membrane (42).

8. The housing (40) according to claim 2, wherein the housing further comprises a metal plating layer (48) and an ink layer (49) that are arranged in sequence on a side, farther away from the first textured membrane (41), of the housing body (43).

9. The housing (40) according to claim 3, wherein the housing further comprises a metal plating layer (48) and an ink layer (49) that are arranged in sequence on a side, farther away from the housing body (43), of the first textured membrane (41).

10. The housing (40) according to claim 4, wherein the housing further comprises a metal plating layer (48) and an ink layer (49) that are arranged in sequence on a side, farther away from the second textured membrane (42), of the first textured membrane (41).

11. An electronic device (01), comprising the housing according to any one of claims 1 to 10, wherein the housing (40) is a front housing (10) or a rear housing (50) of the electronic device (01).

## Patentansprüche

1. Gehäuse (40), umfassend:
einen Gehäusekörper (43), eine erste texturierte Membran (41) und eine flexible zweite texturierte Membran (42), die gestapelt sind, wobei eine Seite, weiter entfernt von der ersten texturierten Membran (41), der zweiten texturierten Membran (42) näher an einer Außenoberfläche (a2) des Gehäuses ist;
wobei die erste texturierte Membran (41) eine erste Texturschicht (411) und eine erste Lagerschicht (412) umfasst, die gestapelt sind, wobei die erste Texturschicht (411) auf einer Seite, weiter entfernt von dem Gehäusekörper (43), der ersten Lagerschicht (412) eingerichtet ist;
wobei die zweite texturierte Membran (42) eine zweite Texturschicht (421) und eine flexible zweite Lagerschicht (422) umfasst, die gestapelt sind, wobei die zweite Texturschicht (421) auf einer Seite, weiter entfernt von dem Gehäusekörper (43), der zweiten Lagerschicht (422) eingerichtet ist;
sich ein Texturmuster der ersten Texturschicht von einem Texturmuster der zweiten Texturschicht unterscheidet;
wobei die flexible zweite texturierte Membran (42) in der Lage ist, sich als Reaktion auf eine externe Kraft zu verformen; und
wobei die erste texturierte Membran (41) eine flexible Struktur ist und die erste texturierte Membran (41) in der Lage ist, sich als Reaktion auf eine externe Kraft zu verformen.

2. Gehäuse (40) nach Anspruch 1, wobei sich der Gehäusekörper (43) auf einer Seite, weiter entfernt von der zweiten texturierten Membran (42), der ersten texturierten Membran (41) befindet; und
das Gehäuse (40) ferner eine erste transparente Verbindungsschicht (44) und eine zweite transparente Verbindungsschicht (45) umfasst, wobei
sich die erste transparente Verbindungsschicht (44) zwischen der ersten texturierten Membran (41) und dem Gehäusekörper (43) befindet und verwendet wird, um die erste texturierte Membran (41) und den Gehäusekörper (43) zu verbinden; und
sich die zweite transparente Verbindungsschicht (45) zwischen der ersten texturierten Membran (41) und der zweiten texturierten Membran (42) befindet und verwendet wird, um die erste texturierte Membran (41) und die zweite texturierte Membran (42) zu verbinden.

3. Gehäuse (40) nach Anspruch 1, wobei die erste texturierte Membran (41) und die zweite texturierte Membran (42) jeweils auf zwei gegenüberliegenden Seiten des Gehäusekörpers (43) eingerichtet sind; und
das Gehäuse (40) ferner eine dritte transparente Verbindungsschicht (53) und eine vierte transparente Verbindungsschicht (54) umfasst, wobei
sich die dritte transparente Verbindungsschicht (53) zwischen der zweiten texturierten Membran (42) und dem Gehäusekörper (43) befindet und verwendet wird, um die zweite texturierte Membran (42) und den Gehäusekörper (43) zu verbinden; und
sich die vierte transparente Verbindungsschicht (54) zwischen der ersten texturierten Membran (41) und dem Gehäusekörper (43) befindet und verwendet wird, um die erste texturierte Membran (41) und den Gehäusekörper (43) zu verbinden.

4. Gehäuse (40) nach Anspruch 1, wobei sich der Gehäusekörper auf einer Seite, weiter entfernt von der ersten texturierten Membran (41), der zweiten texturierten Membran (42) befindet; der Gehäusekörper (43) eine flexible Struktur ist; und
das Gehäuse (40) ferner eine fünfte transparente Verbindungsschicht (55) und eine sechste transparente Verbindungsschicht (56) umfasst, wobei
sich die fünfte transparente Verbindungsschicht (55) zwischen der zweiten texturierten Membran (42) und dem Gehäusekörper (43) befindet und verwendet wird, um die zweite texturierte Membran (42) und den Gehäusekörper (43) zu verbinden; und
sich die sechste transparente Verbindungsschicht (56) zwischen der zweiten texturierten Membran (42) und der ersten texturierten Membran (41) befindet und verwendet wird, um die zweite texturierte Membran (42) und die erste texturierte Membran (41) zu verbinden.

5. Gehäuse (40) nach einem der Ansprüche 1 bis 3, wobei das Gehäuse ferner eine flexible Schutzschicht (46) umfasst, wobei die flexible Schutzschicht (46) auf einer Seite, weiter entfernt von dem Gehäusekörper (43), der zweiten texturierten Membran (42) eingerichtet ist.

6. Gehäuse (40) nach einem der Ansprüche 1 bis 5, wobei, dass sich ein Texturmuster der ersten Texturschicht (411) von einem Texturmuster der zweiten Texturschicht (421) unterscheidet, speziell ist: dass sich das Texturmuster der ersten Texturschicht (411) von dem Texturmuster der zweiten Texturschicht (421) in mindestens einem von Form, Größe, Anordnung oder Platzierungswinkel unterscheidet.

7. Gehäuse (40) nach einem der Ansprüche 1 bis 6, wobei
das Gehäuse (40) ferner eine Bandschicht (47) umfasst, wobei die Bandschicht (47) auf einer Oberfläche der zweiten Lagerschicht (422), näher an oder weiter von dem Gehäusekörper (43) entfernt, eigerichtet ist;
oder
die Bandschicht (47) auf einer Oberfläche der ersten Lagerschicht (412) näher an oder weiter von dem Gehäusekörper (43) entfernt eingerichtet ist;
oder
die Bandschicht (47) auf einer Oberfläche des Gehäusekörpers (43) näher an oder weiter von der zweiten texturierten Membran (42) entfernt eingerichtet ist.

8. Gehäuse (40) nach Anspruch 2, wobei das Gehäuse ferner eine Metallbeschichtungsschicht (48) und eine Tintenschicht (49) umfasst, die auf einer Seite, weiter entfernt von der ersten texturierten Membran (41), des Gehäusekörpers (43) hintereinander angeordnet sind.

9. Gehäuse (40) nach Anspruch 3, wobei das Gehäuse ferner eine Metallbeschichtungsschicht (48) und eine Tintenschicht (49) umfasst, die auf einer Seite, weiter entfernt von dem Gehäusekörper (43), der ersten texturierten Membran (41) hintereinander angeordnet sind.

10. Gehäuse (40) nach Anspruch 4, wobei das Gehäuse ferner eine Metallbeschichtungsschicht (48) und eine Tintenschicht (49) umfasst, die auf einer Seite, weiter entfernt von der zweiten texturierten Membran (42), der ersten texturierten Membran (41) hintereinander angeordnet sind.

11. Elektronische Vorrichtung (01), umfassend das Gehäuse nach einem der Ansprüche 1 bis 10, wobei das Gehäuse (40) ein vorderes Gehäuse (10) oder ein hinteres Gehäuse (50) der elektronischen Vorrichtung (01) ist.

## Revendications

1. Logement (40), comprenant :
un corps de logement (43), une première membrane texturée (41), et une seconde membrane texturée souple (42) qui sont empilées, dans lequel un côté, plus à l'écart de la première membrane texturée (41), de la seconde membrane texturée (42) est plus proche d'une surface externe (a2) du logement ;
dans lequel la première membrane texturée (41) comprend une première couche de texture (411) et une première couche porteuse (412) qui sont empilées, dans lequel la première couche de texture (411) est disposée sur un côté, plus à l'écart du corps de logement (43), de la première couche porteuse (412) ;
dans lequel la seconde membrane texturée (42) comprend une seconde couche de texture (421) et une seconde couche porteuse souple (422) qui sont empilées, dans lequel la seconde couche de texture (421) est disposée sur un côté, plus à l'écart du corps de logement (43), de la seconde couche porteuse (422) ;
un motif de texture de la première couche de texture est différent d'un motif de texture de la seconde couche de texture ;
dans lequel la seconde membrane texturée souple (42) est capable de se déformer en réponse à une force externe ; et
dans lequel la première membrane texturée (41) est une structure souple, et la première membrane texturée (41) est capable de se déformer en réponse à une force externe.

2. Logement (40) selon la revendication 1, dans lequel le corps de logement (43) est localisé sur un côté, plus à l'écart de la seconde membrane texturée (42), de la première membrane texturée (41) ; et
le logement (40) comprend en outre une première couche de liaison transparente (44) et une deuxième couche de liaison transparente (45), dans lequel
la première couche de liaison transparente (44) est localisée entre la première membrane texturée (41) et le corps de logement (43), et est utilisée pour lier la première membrane texturée (41) et le corps de logement (43) ; et
la deuxième couche de liaison transparente (45) est localisée entre la première membrane texturée (41) et la seconde membrane texturée (42), et est utilisée pour lier la première membrane texturée (41) et la seconde membrane texturée (42).

3. Logement (40) selon la revendication 1, dans lequel la première membrane texturée (41) et la seconde membrane texturée (42) sont respectivement disposées sur deux côtés opposés du corps de logement (43) ; et
le logement (40) comprend en outre une troisième couche de liaison transparente (53) et une quatrième couche de liaison transparente (54), dans lequel
la troisième couche de liaison transparente (53) est localisée entre la seconde membrane texturée (42) et le corps de logement (43), et est utilisée pour lier la seconde membrane texturée (42) et le corps de logement (43) ; et
la quatrième couche de liaison transparente (54) est localisée entre la première membrane texturée (41) et le corps de logement (43), et est utilisée pour lier la première membrane texturée (41) et le corps de logement (43).

4. Logement (40) selon la revendication 1, dans lequel le corps de logement est localisé sur un côté, plus à l'écart de la première membrane texturée (41), de la seconde membrane texturée (42) ; le corps de logement (43) est une structure souple ; et
le logement (40) comprend en outre une cinquième couche de liaison transparente (55) et une sixième couche de liaison transparente (56), dans lequel
la cinquième couche de liaison transparente (55) est localisée entre la seconde membrane texturée (42) et le corps de logement (43), et est utilisée pour lier la seconde membrane texturée (42) et le corps de logement (43) ; et
la sixième couche de liaison transparente (56) est localisée entre la seconde membrane texturée (42) et la première membrane texturée (41), et est utilisée pour lier la seconde membrane texturée (42) et la première membrane texturée (41).

5. Logement (40) selon l'une quelconque des revendications 1 à 3, le logement comprenant en outre une couche de protection souple (46), dans lequel la couche de protection souple (46) est disposée sur un côté, plus à l'écart du corps de logement (43), de la seconde membrane texturée (42).

6. Logement (40) selon l'une quelconque des revendications 1 à 5, dans lequel le fait qu'un motif de texture de la première couche de texture (411) soit différent d'un motif de texture de la seconde couche de texture (421) est spécifiquement : le motif de texture de la première couche de texture (411) est différent du motif de texture de la seconde couche de texture (421) dans au moins l'un parmi forme, taille, agencement, ou angle de mise en place.

7. Logement (40) selon l'une quelconque des revendications 1 à 6, le logement (40) comprenant en outre une couche de ruban (47), dans lequel la couche de ruban (47) est disposée sur une surface de la seconde couche porteuse (422) plus près ou plus à l'écart du corps de logement (43) ;
ou
la couche de ruban (47) est disposée sur une surface de la première couche porteuse (412) plus près ou plus à l'écart du corps de logement (43) ;
ou
la couche de ruban (47) est disposée sur une surface du corps de logement (43) plus près ou plus à l'écart de la seconde membrane texturée (42).

8. Logement (40) selon la revendication 2, le logement comprenant en outre une couche de placage métallique (48) et une couche d'encre (49) qui sont agencées en séquence sur un côté, plus à l'écart de la première membrane texturée (41), du corps de logement (43).

9. Logement (40) selon la revendication 3, le logement comprenant en outre une couche de placage métallique (48) et une couche d'encre (49) qui sont agencées en séquence sur un côté, plus à l'écart du corps de logement (43), de la première membrane texturée (41).

10. Logement (40) selon la revendication 4, le logement comprenant en outre une couche de placage métallique (48) et une couche d'encre (49) qui sont agencées en séquence sur un côté, plus à l'écart de la seconde membrane texturée (42), de la première membrane texturée (41).

11. Dispositif électronique (01), comprenant le logement selon l'une quelconque des revendications 1 à 10, dans lequel le logement (40) est un logement avant (10) ou un logement arrière (50) du dispositif électronique (01),
